# EUROPEAN PATENT APPLICATION

(11) **EP 2 147 991 A1**
(43) Date of publication of application: **27.01.2010**
(21) Application number: 08740257.4
(22) Date of filing: 11.04.2008
(51) Int. Cl.: C30B 29/06, C01B 31/04, C04B 35/52, C30B 15/10

(54) **EXPANDABLE GRAPHITE SHEET, METHOD FOR PROTECTING CARBONACEOUS CRUCIBLE USING THE EXPANDABLE GRAPHITE SHEET, AND SINGLE CRYSTAL PULLING APPARATUS**

(30) Priority: 18.04.2007 JP 2007109448
(71) Applicant: Toyo Tanso Co., Ltd., Osaka-shi Osaka 555-0011 (JP)
(72) Inventor: HIROSE, Yoshiaki, Mitoyo-shi Kagawa 769-1102 (JP); YUKI, Tetsuya, Mitoyo-shi Kagawa 769-1102 (JP)
(74) Representative: Glawe, Delfs, Moll
(86) International application number: PCT/JP2008/057160
(87) International publication number: WO 2008/129960

(57) **Abstract**

An expanded graphite sheet with improved tensile strength is provided. By using an expanded graphite sheet with improved tensile strength as a lining for a carbonaceous crucible, a method of protecting a carbonaceous crucible is provided that reduces work hours remarkably, makes it possible to cover the inner surface of the crucible without breaking the sheet or producing gaps, and is suitable for increasing the size of the crucible, and a single-crystal pulling apparatus is also provided.

An expanded graphite sheet (10) is **characterized in that** a reinforcing material (12) comprising carbon fibers is formed in a laminate form on at least one side of a substrate (11) made of an expanded graphite material. Another feature is interposing the expanded graphite sheet (10) between a quartz crucible and a carbonaceous crucible in which the quartz crucible is placed, to use the expanded graphite sheet as a lining for covering an inner surface of the carbonaceous crucible.

## Description

### TECHNICAL FIELD

The present invention relates to an expanded graphite sheet that is reinforced by carbon fibers, a method of protecting a carbonaceous crucible that uses the expanded graphite sheet as a lining for covering the inner surface of the carbonaceous crucible, and a single-crystal pulling apparatus that uses the same.

### BACKGROUND ART

Expanded graphite sheets have excellent heat resistance and excellent gas-liquid impermeability. For this reason, they are used for packing, valve sheets, gaskets, separators for fuel cells, and the like. Patent Document 1 discloses that the expanded graphite sheet is subjected to a refining process under a halogen gas atmosphere at 2000°C or higher to obtain a high-purity expanded graphite sheet with an impurity content of 15 ppm or less. This expanded graphite sheet is used also in a semiconductor manufacturing process.

Hereinbelow, a high-purity expanded graphite sheet used in a semiconductor manufacturing process is described as an example. A typical single-crystal pulling apparatus in a semiconductor manufacturing process is a single-crystal pulling apparatus for a Czochralski process (the process is hereinafter referred to as a "CZ process," and the apparatus is referred to as a "CZ apparatus"). In this single-crystal pulling apparatus for the CZ process, a graphite crucible and a quartz crucible are directly in contact with each other. Therefore, the contact surface of the graphite crucible that is in contact with the quartz crucible turns into silicon carbide (hereinafter SiC) because of the reaction between the quartz crucible and the graphite crucible, or the reaction with the SiO gas or the like that originates from Si, resulting in defects such as cracks, due to the difference in thermal expansion coefficient between SiC and graphite. In order to solve such a problem, it has been proposed that an expanded graphite sheet is interposed between the quartz crucible and the graphite crucible so as to cover the inner surface of the graphite crucible, whereby breakage of the graphite crucible can be prevented to keep the life of the apparatus long (for example, see Patent Document 1).

[Patent Document 1] Japanese Patent No. 2528285

### DISCLOSURE OF THE INVENTION

### PROBLEMS TO BE SOLVED BY THE INVENTION

However, the conventional expanded graphite sheet is weak in terms of strength because it is formed by compressing flocculent expanded graphite. Therefore, the following problems arise when installing the sheet on the inner surface of the crucible.

(1) The inner surface of the graphite crucible has a curved surface shape. For this reason, the expanded graphite sheet may be broken or bent when it is attempted to fit the expanded graphite sheet along the inner surface of the crucible. On the other hand, when it is attempted to fit such a one-piece expanded graphite sheet along the inner surface of the graphite crucible without breaking the sheet, workability is poor, and consequently, a long work hour is necessary.

(2) Moreover, the size of each one expanded graphite sheet tends to become larger as the size of the crucible has become greater. As a consequence, the problems of the breakage of the expanded graphite sheet and the long work hours that is necessary have become more serious.

In order to solve the just-mentioned problems, an expanded graphite sheet with improved strength has been desired.
The demand for the expanded graphite sheet with improved strength also arises from the fields of industry in which the expanded graphite sheet is used, other than the case in which the expanded graphite sheet is used as a lining for covering the inner surface of the graphite crucible.

The present invention has been accomplished in view of the foregoing circumstances, and it is an object of the invention to provide an expanded graphite sheet with improved tensile strength.
It is another object of the invention to provide a method of protecting a carbonaceous crucible that can reduce work hours remarkably, makes it possible to cover the inner surface of the crucible without breaking the sheet or creating gaps, and is suitable for large-sized crucibles, by using the expanded graphite sheet with improved tensile strength as a lining for the carbonaceous crucible.
It is still another object of the invention to provide single-crystal pulling apparatus that can perform uniform heating and manufacture a silicon single crystal that shows few crystal defects.

### MEANS FOR SOLVING THE PROBLEMS

In order to accomplish the foregoing objects, the present invention provides an expanded graphite sheet **characterized in that** a reinforcing material comprising carbon fibers is formed in a laminate form on at least one side of a substrate made of an expanded graphite material.
The just-mentioned configuration enables to construct an expanded graphite sheet with improved tensile strength by the reinforcing material comprising carbon fibers.

In the present invention, it is preferable that the reinforcing material comprise carbon fibers woven in a mesh form. The substrate and the reinforcing material may be united with each other by being bonded together by an adhesive agent. Alternatively, the substrate and the reinforcing material may be united with each other by being compressed in a laminated condition.

In the present invention, the substrate made of an expanded graphite material may contain a reinforcing material in which carbon fibers are entangled with each other.
The term "reinforcing material in which carbon fibers are entangled with each other" means, for example, a reinforcing material in which carbon fibers with fluffy surfaces are entangled with each other to exhibit a reinforcement function. With such a configuration, an expanded graphite sheet with improved tensile strength can be constructed.

The present invention also provides a method of protecting a carbonaceous crucible, characterized by: interposing the expanded graphite sheet according to the invention between a quartz crucible and a carbonaceous crucible in which the quartz crucible is placed, to use the expanded graphite sheet as a lining for covering an inner surface of the carbonaceous crucible.
Here, the term "carbonaceous crucible" is intended to mean a crucible including both a graphite crucible made of a graphite material and a crucible made of a carbon fiber-reinforced carbon composite material (what is called a C/C material, the crucible is hereinafter referred to as a "C/C crucible"). Of course, the graphite crucible and the C/C crucible may be subjected to coating or impregnation with pyrocarbon or the like.
When using the expanded graphite sheet according to the present invention as the lining for covering the inner surface of a carbonaceous crucible by interposing the expanded graphite sheet between a quartz crucible and the carbonaceous crucible in which the quartz crucible is placed, the workability improves remarkably and the required work hour reduces significantly in comparison with when installing the conventional expanded graphite sheet on the inner surface of the carbonaceous crucible, because it becomes unnecessary to pay much attention to the breakage of the sheet. Moreover, since the expanded graphite sheet according to the invention is easy to handle and improves the workability, the protective sheet can be installed on the crucible inner surface without breaking the sheet or taking many work hours even when the size of the crucible increases.

In addition, the present invention provides a single-crystal pulling apparatus using the above-described expanded graphite sheet. The invention also provides a single-crystal pulling apparatus using the above-described method of protecting a carbonaceous crucible. By applying the expanded graphite sheet or the protecting method to a pulling apparatus of silicon single crystal or the like, it becomes possible to cover the inner surface of the crucible without breaking the expanded graphite sheet or without producing gaps. As a result, uniform heating is ensured, and silicon single crystals with few crystal defects can be manufactured.

### ADVANTAGES OF THE INVENTION

The present invention makes available an expanded graphite sheet with improved tensile strength by carbon fibers. In addition, by using the expanded graphite sheet as a lining for a carbonaceous crucible, it becomes possible to reduce work hours remarkably, to cover the inner surface of the crucible without gaps or without breaking the sheet, and moreover, to make the expanded graphite sheet suitable for large-sized crucibles. Furthermore, by applying the expanded graphite sheet according to the present invention or the method of protecting a carbonaceous crucible according to the present invention to a pulling apparatus of silicon single crystal or the like, uniform heating is ensured, and silicon single crystals with few crystal defects can be manufactured.

### BEST MODE FOR CARRYING OUT THE INVENTION

Hereinbelow, the present invention will be described based on the preferred embodiments. It should be noted that the present invention is not limited to the following embodiments.

### [EMBODIMENT 1]

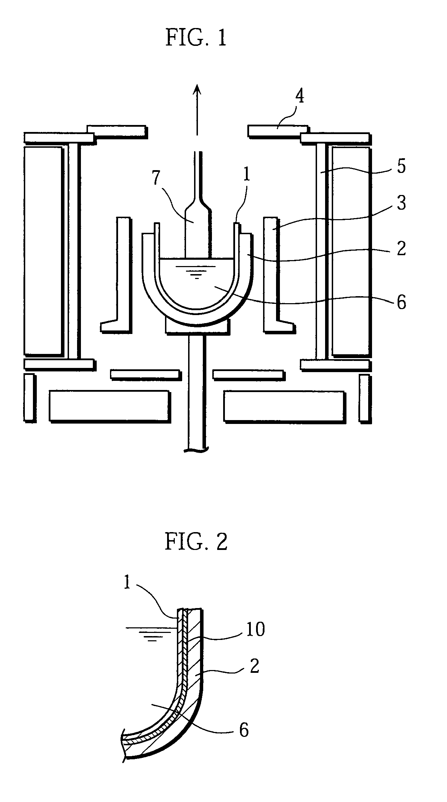

The following embodiment describes a case in which the expanded graphite sheet according to the present invention is applied to a lining for covering the inner surface of a carbonaceous crucible.
First, a schematic configuration of crucibles in the single-crystal pulling apparatus shown in Fig. 1 will be described, and then, the expanded graphite sheet according to the present invention will be described.

### (Configuration of Single-crystal Pulling Apparatus)

Fig. 1 is a cross-sectional view illustrating a primary portion of a single-crystal pulling apparatus, and Fig. 2 is an enlarged cross-sectional view of a crucible.
As illustrated in Fig. 1, a CZ apparatus comprises a carbonaceous crucible 2 that supports a quartz crucible 1, a heater 3, an upper ring 4, an inner shield 5, and so forth. Thus, the CZ apparatus obtains a single crystal 7 by heating a source material in the quartz crucible 1 to a high temperature by the heater 3 disposed around the quartz crucible 1 to obtain a source material melt 6, and pulling the source material melt 6.

As illustrated in Fig. 1, the carbonaceous crucible 2 is directly in contact with the quartz crucible 1. For this reason, the surface of the carbonaceous crucible 2 that is in contact with the quartz crucible 1 turns into silicon carbide (hereinafter SiC), because of the reaction between the quartz crucible and the carbonaceous crucible, or the reaction with the SiO gas or the like that originates from Si, resulting in defects such as cracks, due to the difference in thermal expansion coefficient between SiC and graphite. In order to solve the just-mentioned problem, an expanded graphite sheet 10 according to the present invention is interposed as a lining between the quartz crucible 1 and the carbonaceous crucible 2, as illustrated in Fig. 2.

### (Structure of the Expanded Graphite Sheet)

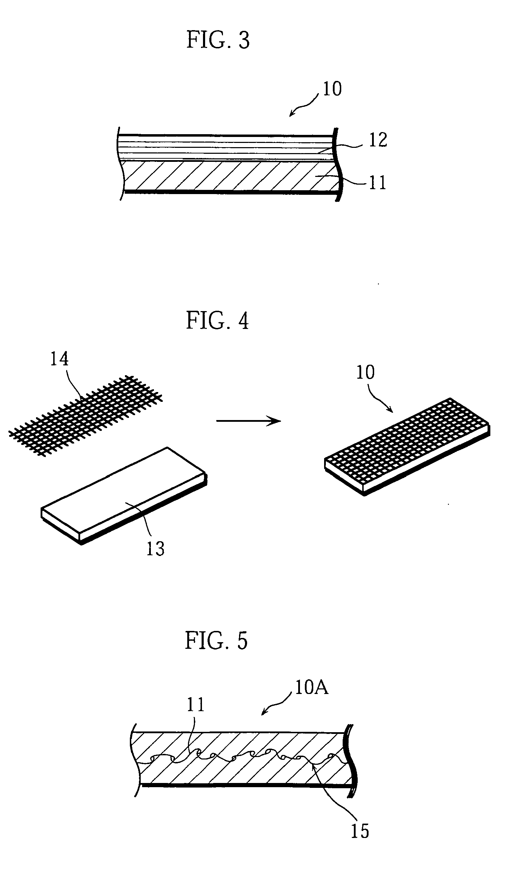

As illustrated in Fig. 3, the expanded graphite sheet 10 is made by forming a reinforcing material 12 comprising carbon fibers on one side of a substrate 11 made of an expanded graphite material in a laminate form. The reinforcing material 12 is made by weaving carbon fibers in a mesh form. The reinforcing material 12 and the substrate 11 are united with each other by being bonded by an adhesive agent. The tensile strength of the expanded graphite sheet 10 improves because it has such a reinforcing material 12 in which carbon fibers are woven in a mesh form. As a result, when the expanded graphite sheet 10 is used as a lining for a carbonaceous crucible, it is possible to reduce work hours remarkably, to cover the inner surface of the crucible without gaps or without breaking the sheet, and moreover, to make the expanded graphite sheet 10 suitable for large-sized crucibles.

### (Manufacturing method of the Expanded Graphite Sheet)

Next, a manufacturing method of the expanded graphite sheet 10 will be described with reference to Fig. 4.
An expanded graphite sheet 13 that serves as the substrate of the expanded graphite sheet 10 is a sheet-shaped material made of expanded graphite. A typical example thereof is as follows. First, natural or synthetic graphite flakes, kish graphite, or the like are treated with an oxidizing agent, to form an intercalation compound in the graphite particles. Next, this is heated to a high temperature, or preferably exposed abruptly to a high temperature to expand the material rapidly. This treatment causes the graphite particles to expand in a direction perpendicular to the layer plane due to the gas pressure of the intercalation compound of the graphite particles, so that the volume expands from about 100 times to 250 times. The oxidizing agent used in this case is one that forms an intercalation compound, such as a mixed acid of a sulfuric acid and a nitric acid, and a sulfuric acid to which an oxidizing agent such that a sodium nitrate, a potassium permanganate, or the like is added.
Subsequently, the expanded graphite is formed into a sheet shape by an appropriate means, for example, by compressing or roll-pressing, to prepare the expanded graphite sheet 13 having a bulk density of from 0.1 Mg/m³ to 0.7 Mg/m³.

A sheet 14 in which carbon fibers are woven in a mesh form is prepared in the following manner. Carbon fibers are formed into twine having a diameter of 0.5 mm, and the resulting carbon fibers are woven in a mesh form using the carbon fibers as warp and weft to prepare the carbon fiber sheet 14. Examples of the weave include plain weave, twill weave, and satin weave.

Subsequently, the carbon fiber sheet 14 prepared in the above-described manner is bonded onto one side of the expanded graphite sheet 13 prepared in the above-described manner, which serves as the substrate, by an adhesive agent. Examples of the adhesive agent include thermosetting resins, such as phenolic resins.
Next, the resultant composite material is subjected to a refining process under a halogen gas atmosphere at 2000°C or higher, whereby the expanded graphite sheet 10 according to the invention that has an impurity content of 50 ppm or less, preferably 30 ppm or less, is prepared.

### [EMBODIMENT 2]

The expanded graphite sheet 10 according to Embodiment 2 is **characterized in that** the substrate 11 and the reinforcing material 12 are united with each other by compressing.
The expanded graphite sheet 10 may be manufactured in the following manner. Specifically, the expanded graphite sheet 13 prepared in the same manner as described in Embodiment 1 above, which serves as the substrate, and the carbon fiber sheet 14 prepared in the same manner as described in Embodiment 1 above were laminated, and the expanded graphite sheet 13 serving as the substrate and the carbon fiber sheet 14 were compressed to have a bulk density of from 1.0 Mg/m³ to 2.0 Mg/m³ by rolling or pressing. Thus, a composite material in which the expanded graphite sheet 13 and the carbon fiber sheet 14 are combined together was prepared. Subsequently, the resultant composite material was subjected to a refining process under a halogen gas atmosphere at 2000°C or higher, to thus prepare the expanded graphite sheet 10 according to the invention having an impurity content of 50 ppm or less, preferably 30 ppm or less.

### [EMBODIMENT 3]

The reinforcing material 15 in an expanded graphite sheet 10A according to Embodiment 3 is **characterized in that** the carbon fibers are entangled with each other, as illustrated in Fig. 5. An improvement in strength can be achieved when the expanded graphite sheet is constructed by carbon fibers entangled with each other, even if the carbon fibers are not woven in a mesh form as described above.

The expanded graphite sheet 10A may be manufactured in the following manner. Specifically, the flocculent expanded graphite obtained by the expansion treatment described in Embodiment 1, and carbon fibers that had a length of 3 mm or longer and a diameter of 0.1 mm or greater and had fluffy surfaces were mixed. Then, the mixture in which the fluffy carbon fibers were entangled with each other was put into a mold, and the materials were combined by press-molding or roll-pressing, to prepare a composite material.
Subsequently, the resultant composite material was subjected to a refining process under a halogen gas atmosphere at 2000°C or higher, to thus prepare the expanded graphite sheet 10A according to the invention having an impurity content of 50 ppm or less, preferably 30 ppm or less.

### (Other Embodiments)

(1) In Embodiments 1and 2 above, the carbon fiber sheet 14 is provided on one side of the expanded graphite sheet 13 that serves as the substrate. However, it is possible to provide the carbon fiber sheets 14 on both sides of the expanded graphite sheet 13 that serves as the substrate. In this way, the sheet strength can be improved further, and therefore, the resulting sheet is more suitable for a lining for the crucible.

(2) It is possible to use a material that turns into carbon by a heat treatment, such as an organic fiber sheet, in place of the carbon fiber sheet because the refining process is carried out after the expanded graphite sheet 13 serving as the substrate and the carbon fiber sheet 14 are combined together. In short, any material that can turn into carbon by a heat treatment may be used.

### EXAMPLES

Hereinbelow, the present invention will be described in detail by examples. It should be noted that the present invention is in no way limited to the following examples.

### (Example 1)

An expanded graphite sheet according to the present invention (hereinafter referred to as a "present invention expanded graphite sheet A1") was prepared in the same manner as described in Embodiment 1 above, and a tensile test was conducted (using a material testing machine 4301 made by Instron Inc.). The result is shown in Table 1 below. In the tensile test, the tensile strength was calculated from the breaking load when a tensile stress was applied to each sample (20 mm × 100 mm) at a uniform velocity of 8.3 × 10⁻² mm/s.

**[TABLE 1]**

| Sheet | Tensile strength (MPa) |
|---|---|
| Prevent invention sheet A1 | 15 |
| Prevent invention sheet A2 | 12 |
| Prevent invention sheet A3 | 10 |
| Comparative sheet Z | 5 |

The expanded graphite sheet according to the present invention had a thickness of 0.4 mm and a bulk density of 1.0 Mg/m³.

### (Example 2)

An expanded graphite sheet according to the present invention (hereinafter referred to as a "present invention expanded graphite sheet A2") was prepared in the same manner as described in Embodiment 2 above, and a tensile test was conducted in the same manner as described in Example 1 above. The result is also shown in Table 1.

### (Example 3)

An expanded graphite sheet according to the present invention (hereinafter referred to as a "present invention expanded graphite sheet A3") was prepared in the same manner as described in Embodiment 3 above, and a tensile test was conducted in the same manner as described in Example 1 above. The result is also shown in Table 1.

### (Comparative Example)

Natural graphite flakes that had been subjected to an acid treatment were carefully selected and subjected to a high temperature expansion treatment. Thereafter, the impurity of the expanded graphite was removed so that the ash content would be 50 ppm or less. Then, the resultant expanded graphite was formed into a sheet shape by an appropriate means, such as compressing or roll-forming, to prepare a common high-purity expanded graphite sheet (hereinafter referred to as a "comparative expanded graphite sheet Z") in which carbon fibers are not combined. A tensile test was conducted in the same manner as described in Example 1 above. The result is also shown in Table 1.

### (Analysis of the Test Results)

As clearly seen from Table 1, all the present invention expanded graphite sheets A1, A2, and A3 exhibited better tensile strengths than the comparative expanded graphite sheet Z. It is believed that this result was obtained because the tensile strength improved due to the carbon fibers. This demonstrates that the present invention expanded graphite sheets can be suitably used as a lining in a graphite crucible.
It should be noted that the present invention expanded graphite sheets A1 and A2 showed better tensile strengths than that of the present invention expanded graphite sheet A3. It is believed that this demonstrates that the one in which carbon fibers are woven in a mesh form has a better tensile strength.

### INDUSTRIAL APPLICABILITY

The present invention is suitable for an expanded graphite sheet that is reinforced by carbon fibers, a method of protecting a carbonaceous crucible that uses the expanded graphite sheet as a lining for covering the inner surface of the carbonaceous crucible, and a single-crystal pulling apparatus that uses the same.

### BRIEF DESCRIPTION OF THE DRAWINGS

[Fig. 1] Fig. 1 is a cross-sectional view illustrating a primary portion of a single-crystal pulling apparatus.
[Fig. 2] Fig. 2 is an enlarged cross-sectional view of a crucible.
[Fig. 3] Fig. 3 is a schematic cross-sectional view illustrating an expanded graphite sheet according to the present invention.
[Fig. 4] Fig. 4 is a view illustrating a manufacturing method of the expanded graphite sheet according to the present invention.
[Fig. 5] Fig. 5 is a schematic cross-sectional view illustrating an expanded graphite sheet according to the present invention.

### DESCRIPTION OF REFERENCE NUMERALS

- 1:: quartz crucible
- 2:: carbonaceous crucible
- 3:: heater
- 4:: upper ring
- 5:: inner shield
- 6:: source material melt
- 7:: single crystal
- 10, 10A:: expanded graphite sheet according to the present invention
- 11:: substrate
- 12, 15:: reinforcing material
- 13:: expanded graphite sheet serving as a substrate
- 14:: carbon fiber sheet

## Claims

1. An expanded graphite sheet **characterized in that** a reinforcing material comprising carbon fibers is formed in a laminate form on at least one side of a substrate made of an expanded graphite material.

2. The expanded graphite sheet according to claim 1, wherein the reinforcing material comprises carbon fibers woven in a mesh form.

3. The expanded graphite sheet according to claim 2, wherein the substrate and the reinforcing material are united with each other by being bonded together by an adhesive agent.

4. The expanded graphite sheet according to claim 2, wherein the substrate and the reinforcing material are united with each other by being compressed in a laminated condition.

5. An expanded graphite sheet **characterized in that** a substrate made of an expanded graphite material contains a reinforcing material in which carbon fibers are entangled with each other.

6. A method of protecting a carbonaceous crucible, **characterized by**: interposing an expanded graphite sheet according to any one of claims 1 through 5 between a quartz crucible and a carbonaceous crucible in which the quartz crucible is placed, to use the expanded graphite sheet as a lining for covering an inner surface of the carbonaceous crucible.

7. A single-crystal pulling apparatus using an expanded graphite sheet according to any one of claims 1 through 5.

8. A single-crystal pulling apparatus using a protecting method according to claim 6.
